# EUROPEAN PATENT SPECIFICATION

(11) **EP 3 428 776 B1**
(45) Date of publication and mention of the grant of the patent: **30.12.2020**
(21) Application number: 17773142.9
(22) Date of filing: 23.03.2017
(51) Int. Cl.: G11C 5/14, G11C 16/30, G06F 1/30

(54) **BACKUP POWER CIRCUIT AND ELECTRICAL DEVICE**
RESERVESTROMKREIS UND ELEKTRISCHE VORRICHTUNG
CIRCUIT D'ALIMENTATION DE SECOURS ET DISPOSITIF ÉLECTRIQUE

(30) Priority: 31.03.2016 CN 201610199983
(43) Date of publication of application: 16.01.2019
(73) Proprietor: Huawei Technologies Co., Ltd., Longgang District Shenzhen, Guangdong 518129 (CN)
(72) Inventor: CHEN, Guan, Shenzhen Guangdong 518129 (CN); YU, Xiao, Shenzhen Guangdong 518129 (CN); WANG, Debo, Shenzhen Guangdong 518129 (CN)
(74) Representative: Epping - Hermann - Fischer
(86) International application number: PCT/CN2017/077865
(87) International publication number: WO 2017/167112

(56) References cited:
- CN-A- 101 625 873
- CN-A- 102 156 679
- CN-A- 105 279 109
- CN-A- 105 867 573
- CN-U- 204 615 435
- DE-A1- 3 023 190
- JP-A- H03 251 045
- JP-A- S60 140 413
- US-A1- 2008 164 760
- US-A1- 2012 117 409

## Description

### TECHNICAL FIELD

The present invention relates to the field of backup power technologies, and in particular, to a backup power circuit and an electrical device.

### BACKGROUND

In a storage device, an SSD (Solid-state Drive, solid-state drive) is a new-type storage device that is based on a semiconductor solid-state memory technology. The SSD has advantages, such as a high read/write speed, high shock resistance, a large temperature range, a small volume, and a light weight, over a conventional mechanical hard disk.

In the prior art, a write operation performed by a host device on the SSD has two modes: a write-through (Write-Through) mode and a write-back (Write-Back) mode. A speed of the write-back mode is higher than that of the write-through mode. However, in the write-back mode, the SSD first writes data in a buffer (buffer) of the SSD, and then returns a message indicating a write success to the host device, and the host device considers that the SSD has completed data storage. Then, a main control chip of the SSD flushes the data to a back-end flash memory (FLASH) chip of the SSD. If a platter of the SSD is powered off in this case, data in the buffer will be lost. Therefore, in SSD design, usually a backup power circuit is added. The backup power circuit includes some capacitors that are connected in parallel. One end of each of the some capacitors is connected between an input end and an output end of the backup power circuit, and the other end is grounded. The backup power circuit is used to provide the SSD with electric energy required, when unexpected power-off occurs, for flushing the data in the buffer to the flash memory chip, so as to avoid a data loss.

However, the prior art has the following problems:
Because the capacitors in the backup power circuit are mutually connected in parallel, if one of the capacitors is short-circuited, the entire backup power circuit fails, thereby affecting a backup power effect of the backup power circuit.

CN 204 615 435 U discloses a quick reserve power supply unit of energy storage type, including power input connector, input/output control circuit, high power capacity energy storage unit and power output interface, input/output control circuit includes three isolating diode and charges regulating electrical resistance, the power input connector series branch of forming through an isolating diode and the regulating electrical resistance that charges and high power capacity energy storage unit connection of the same kind, the 2nd isolating diode directness and power output interface connection is crossed to another sweetgum fruit, high power capacity energy storage unit mainly comprises the high power capacity of the parallelly connected or mixed hookup of establishing ties, the connection is held through the 3rd isolating diode with the power output interface of being connected the 2nd isolating diode to the connection of the high power capacity energy storage unit regulating electrical resistance RC end that charges.

DE 3023190 A1 discloses a capacitor battery for generation of electrical pulses, the capacitor battery comprising n parallel capacitor branches, wherein each branch comprises two diodes to avoid short circuits in case of capacitor failures.

### SUMMARY

To improve a backup power effect of a backup power circuit, embodiments of the present invention provide a backup power circuit and an electrical device.

The invention is defined in independent claim 1, advantageous embodiments are defined in dependent claims 2 - 7.

The technical solutions are as follows:
According to a first aspect, a backup power circuit is provided, where an output end of the backup power circuit is electrically connectable to an input end of a power supply circuit of an electrical device, an input end of the backup power circuit is connectable to an output end of the power supply circuit, the backup power circuit includes a backup power branch array including N backup power branches that are mutually connected in parallel, N is an integer greater than or equal to 2, and each backup power branch includes a capacitor component and a unilateral conductive element;
the unilateral conductive element is electrically connected to an input end of the backup power branch array, an output end of the backup power branch array, and the capacitor component separately; and
the unilateral conductive element is configured to cut off a current path between the N backup power branches that are mutually connected in parallel, and the unilateral conductive element allows a current to flow into the input end of the backup power branch array and flow out from the output end of the backup power branch array.

The backup power branch array including the N backup power branches that are mutually connected in parallel is disposed, and in each backup power branch array, a current path between capacitor components in different backup power branches is cut off by using the unilateral conductive element. When some backup power branches are short-circuited, it can be ensured that backup power functions of other backup power branches are not affected, so that backup power effects of the backup power branches are improved.

In a first possible implementation of the first aspect, the unilateral conductive element includes a first diode and a second diode; a negative electrode of the first diode is electrically connected to a positive electrode of the second diode, a positive electrode of the first diode is electrically connected to the input end of the backup power branch array, and a negative electrode of the second diode is electrically connected to the output end of the backup power branch array; and the capacitor component includes M capacitors that are mutually connected in parallel, one end of each capacitor is connected between the negative electrode of the first path between capacitor components in different backup power branches is cut off by using the unilateral conductive element. When some backup power branches are short-circuited, it can be ensured that backup power functions of other backup power branches are not affected, so that backup power effects of the backup power branches are improved.

The unilateral conductive element includes a first diode and a second diode; a negative electrode of the first diode is electrically connected to a positive electrode of the second diode, a positive electrode of the first diode is electrically connected to the input end of the backup power branch array, and a negative electrode of the second diode is electrically connected to the output end of the backup power branch array; and the capacitor component includes M capacitors that are mutually connected in parallel, one end of each capacitor is connected between the negative electrode of the first diode and the positive electrode of the second diode, the other end of each capacitor is grounded, and M is an integer greater than or equal to 1.

A current path between different backup power branches is cut off by using the first diode and the second diode, so that when some backup power branches are short-circuited, backup power effects of other backup power branches are not affected.

A capacitance of each capacitor is Cmin, and Cmin satisfies Cmin^{∗}M^{∗}(N-x)^{∗}(Vmax-Vmin)≥Q, where x is an integer greater than or equal to 1, Vmax is a maximum discharge voltage of the backup power branch array, Vmin is a minimum discharge voltage of the backup power branch array, and Q is a quantity of electric charges required for effectively supplying power to the storage device for preset duration.

Each backup power branch further includes a resistor, one end of the resistor is electrically connected to the negative electrode of the first diode, and the other end of the resistor is electrically connected to the positive electrode of the second diode; and one end of each capacitor is connected between the resistor and the positive electrode of the second diode.

The resistor is disposed in the backup power branch to limit a value of a current of the backup power branch when the capacitor in the backup power branch is short-circuited, so that another backup power branch can obtain a sufficient current for charging, thereby mitigating impact of a short circuit of some of backup power branches on the another backup power branch.

In a first possible implementation of the first aspect, a resistance R of the resistor satisfies: $\left(Vcap/R\right) ∗ N < A 0 - A 1 ,$ where
Vcap is a charge voltage of the N backup power branches that are mutually connected in parallel, A0 is a maximum charge current of the backup power circuit, and A1 is a preset current value.

In a second possible implementation of the first aspect, the backup power circuit further includes a third diode; and
the third diode is connected to the backup power branch array in parallel, where a positive electrode of the third diode is electrically connected to the input end of the backup power branch array, and a negative electrode of the third diode is electrically connected to the output end of the backup power branch array.

In a third possible implementation of the first aspect, the backup power circuit further includes a constant current source;
the constant current source includes an input end, an output end, and a control end;
the input end of the constant current source is electrically connected to the output end of the backup power branch array;
the output end of the constant current source is grounded; and
the control end of the constant current source is electrically connected to the control chip.

With reference to any one of the first aspect, or the first to the third possible implementations of the first aspect, in a fourth possible implementation of the first aspect, each of the M capacitors that are mutually connected in parallel is at least one of an electrolytic aluminum capacitor, a polymer solid tantalum capacitor, a polymer solid aluminum capacitor, or a ceramic capacitor.

According to a second aspect, an electrical device is provided, where the electrical device includes the backup power circuit according to any one of the first aspect, or the possible implementations of the first aspect.

In a first possible implementation of the second aspect, the electrical device is a storage device.

### BRIEF DESCRIPTION OF DRAWINGS

To describe the technical solutions in the embodiments of the present invention more clearly, the following briefly describes the accompanying drawings required for describing the embodiments. Apparently, the accompanying drawings in the following description show merely some embodiments of the present invention, and a person of ordinary skill in the art may still derive other drawings from these accompanying drawings without creative efforts.
FIG. 1 is a circuit diagram of an electrical device according to an example embodiment of the present invention;

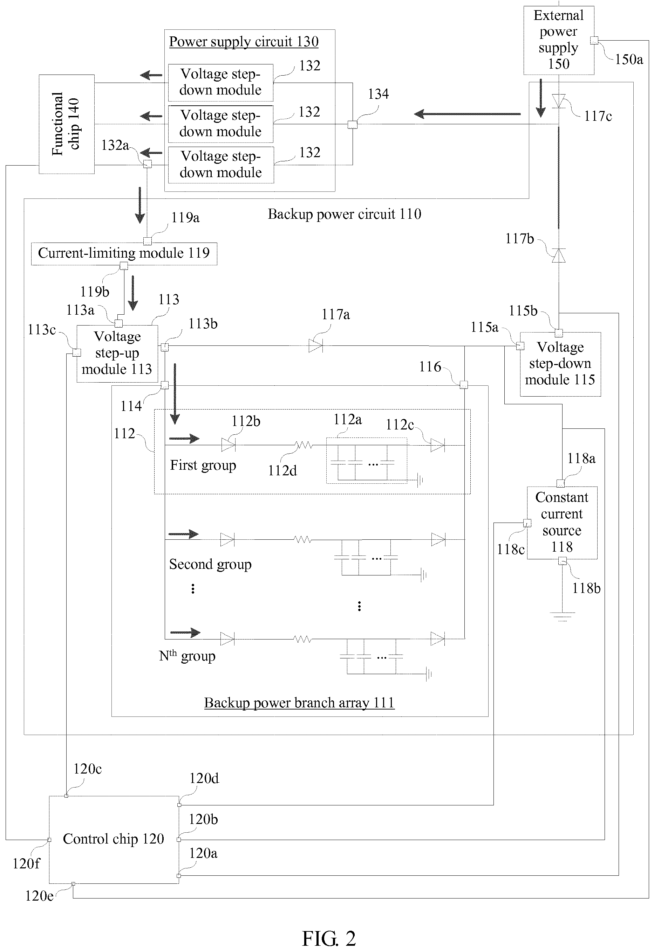

FIG. 2 is a schematic diagram of a flow direction of a current when a backup power circuit is being charged according to the embodiment corresponding to FIG. 1;

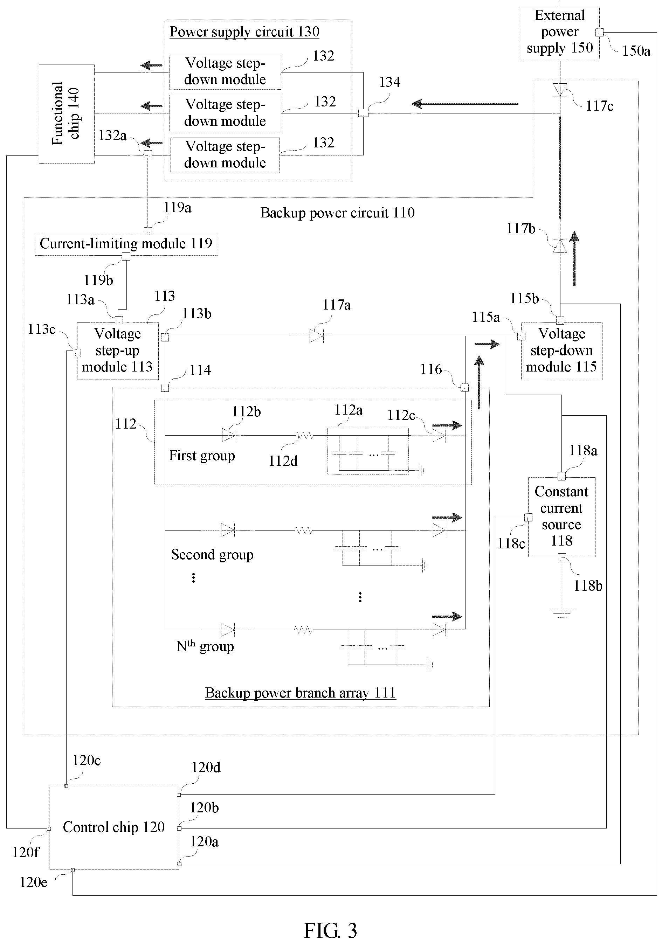

FIG. 3 is a schematic diagram of a flow direction of a current when a backup power circuit is being discharged according to the embodiment corresponding to FIG. 1; and

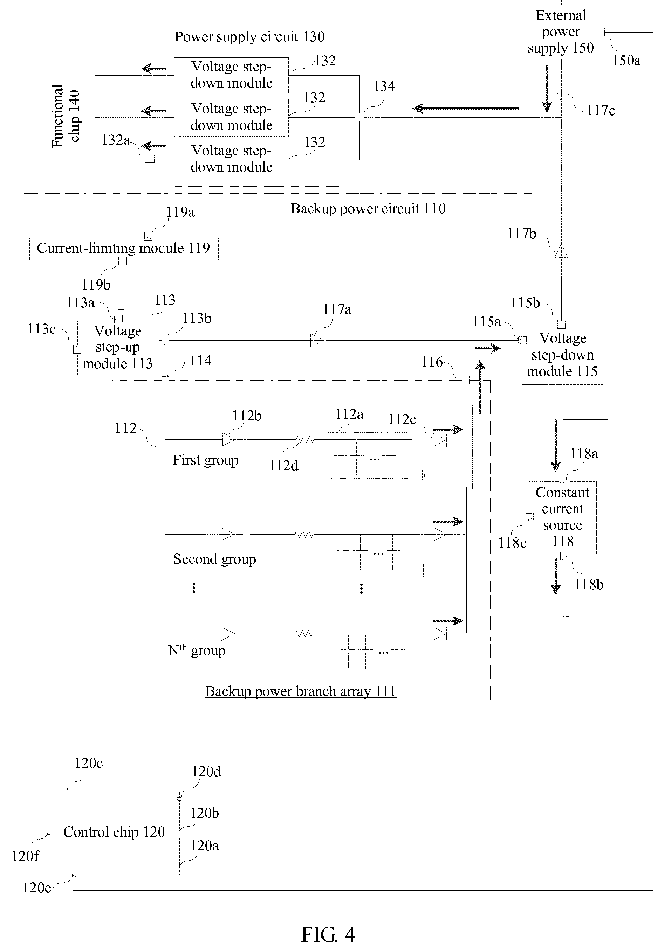

FIG. 4 is a schematic diagram of a flow direction of a current when a backup power circuit performs a self-test according to the embodiment corresponding to FIG. 1.

### DESCRIPTION OF EMBODIMENTS

To make the objectives, technical solutions, and advantages of the present invention clearer, the following further describes the embodiments of the present invention in detail with reference to the accompanying drawings.

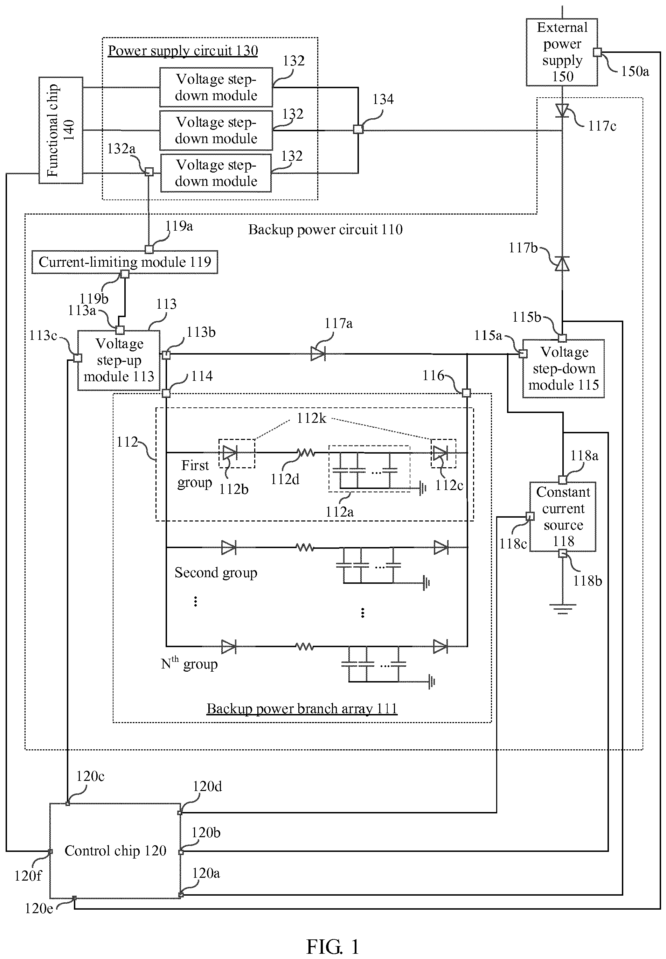

Referring to FIG. 1, FIG. 1 is a circuit diagram of an electrical device according to an example embodiment of the present invention. The electrical device includes a backup power circuit 110, a control chip 120, a power supply circuit 130, and a functional chip 140.

An output end of the backup power circuit 110 is electrically connected to an input end of the power supply circuit 130 of the electrical device, an input end of the backup power circuit 110 is connected to an output end of the power supply circuit 130, and the input end of the power supply circuit 130 is further electrically connected to an output end of an external power supply 150. Typically, the electrical device may be a storage device, such as an SSD.

The backup power circuit 110 includes a backup power branch array 111 including N backup power branches 112 that are mutually connected in parallel, where N is an integer greater than or equal to 2. Each backup power branch includes a capacitor component 112a and a unilateral conductive element 112k, where the unilateral conductive element 112k is electrically connected to an input end 114 of the backup power branch array, an output end 116 of the backup power branch array, and the capacitor component 112a separately. The unilateral conductive element 112k is configured to cut off a current path between the N backup power branches 112 that are mutually connected in parallel, that is, when a capacitor component 112a in a backup power branch 112 is short circuited, electric energy stored in a capacitor component 112a in another backup power branch 112 cannot flow into the short-circuited backup power branch 112. In addition, the unilateral conductive element 112k allows a current to flow into the input end 114 of the backup power branch array and flow out from the output end 116 of the backup power branch array.

Optionally, the unilateral conductive element 112k includes a first diode 112b and a second diode 112c, each backup power branch 112 further includes a resistor 112d, and each capacitor component 112a includes M capacitors that are mutually connected in parallel. One end of each capacitor is connected between the resistor 112d and a positive electrode of the second diode 112c, the other end of each capacitor is grounded, and M is an integer greater than or equal to 1.

One end of the resistor 112d is electrically connected to a negative electrode of the first diode 112b, the other end of the resistor 112d is electrically connected to the positive electrode of the second diode 112c, a positive electrode of the first diode 112b is electrically connected to the input end 114 of the backup power branch array 111, and a negative electrode of the second diode 112b is electrically connected to the output end 116 of the backup power branch array 111. The first diode and the second diode are configured to cut off the current path between the N backup power branches that are mutually connected in parallel.

In this embodiment of the present invention, an example in which the unilateral conductive element 112k includes the first diode 112b and the second diode 112c is used for description. In actual application, the unilateral conductive element may have another element or structure. For example, in the unilateral conductive element, more diodes may be used to replace the first diode 112b and the second diode 112c. Alternatively, the first diode 112b and the second diode 112c in the unilateral conductive element may be replaced with other elements with same functions as the diodes, such as an ionic tube, a rectifier, and a silicon controlled thyristor with unilateral conductivity, and a unilateral conductive adhesive. No limitation is imposed on a composition and a structure of the unilateral conductive element 112k in this embodiment of the present invention.

In actual application, each of the M capacitors that are mutually connected in parallel may be a capacitor having a voltage with a relatively high rating, such as an ordinary electrolytic aluminum capacitor, a polymer (polymer) solid tantalum capacitor, a polymer solid aluminum capacitor, or a ceramic capacitor. The four capacitors are merely examples for description. The M capacitors that are mutually connected in parallel and required in the present invention need to have voltages with relatively high ratings, and no limitation is imposed on a selection range of the capacitors in the present invention.

The control chip 120 is configured to: measure a capacitance of the backup power branch array 111 according to a preset period, determine whether a total capacitance is less than a first preset threshold, and if the total capacitance is less than the first preset threshold, generate prompt information indicating that duration for which the backup power circuit 110 can effectively supply power to the electrical device is less than preset duration. For example, the control chip 120 may send the prompt information to a host device connected to the electrical device.

In addition, the backup power circuit 110 further includes a third diode 117a, a fourth diode 117b, and a fifth diode 117c. A positive electrode of the fifth diode 117c is connected to the external power supply 150, and a negative electrode of the fourth diode 117b is electrically connected to a negative electrode of the fifth diode 117c, to form a repelling structure, to prevent a current that flows out from the external power supply 150 from flowing into the backup power branch array 111 when the external power supply 150 works normally, and prevent a current that flows out from the backup power branch array 111 from flowing into the external power supply 150 when the external power supply 150 powers off.

Similarly, the third diode 117a, the fourth diode 117b, and the fifth diode 117c may alternatively have another element or structure. For example, the third diode 117a, the fourth diode 117b, and the fifth diode 117c each may include a plurality of diodes. Alternatively, the third diode 117a, the fourth diode 117b, and the fifth diode 117c may be replaced with other elements with same functions as the diodes, such as an ionic tube, a rectifier, and a silicon controlled thyristor with unilateral conductivity, and a unilateral conductive adhesive.

The input end 134 of the power supply module 130 is electrically connected to the negative electrode of the fourth diode 117b and the negative electrode of the fifth diode 117c. The power supply module 130 includes a plurality of voltage step-down modules 132, and each voltage step-down module 132 correspondingly supplies power to one or more functional chips 140. The voltage step-down module 132 in the power supply module 130 is set, according to an electrical requirement of a functional chip 140 corresponding to the voltage step-down module 132, to output different voltage values. For example, these output voltage values may be 1.0 V, 1.8 V, 3.3 V, 5.6 V, 6.8 V, or the like. The foregoing values are merely used as examples to describe voltage values that can be output by the voltage step-down module 132 in the power supply module 130, and impose no limitation on a voltage value output by the voltage step-down module 132 in the power supply module 130.

As shown in FIG. 1, the backup power circuit 110 further includes a voltage step-up module 113, a voltage step-down module 115, a constant current source 118, and a current-limiting module 119. The current-limiting module 119 includes an input end 119a and an output end 119b, the voltage step-up module 113 includes an input end 113a, an output end 113b, and a control end 113c, the voltage step-down module 115 includes an input end 115a and an output end 115b, and the constant current source 118 includes a current input end 118a, a current output end 118b, and a control end 118c. The control chip 120 includes at least a first interface 120a, a second interface 120b, a third interface 120c, a fourth interface 120d, a fifth interface 120e, and a sixth interface 120f.

An output end 132a of a voltage step-down module 132 in the power supply circuit 130 is electrically connected to the input end 119a of the current-limiting module 119, the output end 119b of the current-limiting module 119 is electrically connected to the input end 113a of the voltage step-up module 113, the output end 113b of the voltage step-up module 113 is electrically connected to the input end 114 of the backup power branch array 111 and a positive electrode of the third diode 117a separately, and the control end 113c of the voltage step-up module 113 is electrically connected to the third interface 120c of the control chip 120. The input end 115a of the voltage step-down module 115 is electrically connected to a negative electrode of the third diode 117a and the output end 116 of the backup power branch array 111 separately, the output end 115b of the voltage step-down module 115 is electrically connected to a positive electrode of the fourth diode 117b and the first interface 120a of the control chip 120 separately, the current input end 118a of the constant current source 118 is electrically connected to the second interface 120b of the control chip 120 and the output end 116 of the backup power branch array 111 separately, the current output end 118b of the constant current source 118 is grounded, the control end 118c of the constant current source 118 is electrically connected to the fourth interface 120d of the control chip 120, and the fifth interface 120e of the control chip 120 is electrically connected to a control end 150a of the external power supply. The sixth interface 120f of the control chip 120 is a power supply interface of the control chip 120.

The current-limiting module 119 is configured to limit a current entering the voltage step-up module 113 below a preset maximum current. That is, a value of the current entering the backup power circuit 110 is limited, to prevent the foregoing components from being burned due to an excessive current, thereby providing current-limiting protection for the backup power circuit 110, the voltage step-up module 113, the voltage step-down module 115, the third diode 117a, and the fourth diode 117b. The current-limiting module 119 may be a current-limited (Current limit) circuit module.

The voltage step-up module 113 is configured to step up a voltage the current entering the voltage step-up module 113, so as to increase electric energy that can be charged into capacitors in the N backup power branches 112 that are mutually connected in parallel (a higher voltage of a capacitor indicates more electric charges in the capacitor). The voltage step-up module 113 may be a switch direct current boost (Boost) circuit module.

The voltage step-down module 115 is configured to: when the backup power circuit 110 supplies power to the electrical device, step down a voltage for electric energy stored in the backup power branch array 111 and output a voltage obtained after the voltage step-down to the voltage step-down modules 132 in the power supply module 130. Then the voltage step-down modules 132 perform secondary voltage step-down and transport a voltage obtained after the secondary voltage step-down to the functional chips 140. The voltage step-down module 115 may be a buck (Buck) conversion circuit module.

The constant current source 118 is configured to provide a constant current output path for the output end 116 of the backup power branch array 111, so that the control chip 120 measures a capacitance of the backup power branch array 111.

The control device 120 collects, by using the first interface 120a, a voltage that is at the output end 116 of the backup power branch array 111 and that is obtained after voltage step-down by the voltage step-down module 115. The first interface 120a may be an analog-to-digital converter (Analog-to-Digital Converter, ADC) interface in the control chip 120.

The control device 120 detects a voltage at the input end of the constant current source 118 by using the second interface 120b, and the second interface 120b may be another ADC interface in the control chip 120.

The control device 120 controls, by using the third interface 120c, running of the voltage step-up module 113, including controlling enabling and disabling of the voltage step-up module 113. The third interface may be a general purpose input/output (General Purpose Input Output, GPIO) interface in the control chip 120.

The control device 120 controls, by using the fourth interface 120d, running of the constant current source 118, including controlling enabling and disabling of the constant current source 118. The fourth interface may be another general purpose input/output interface in the control chip 120.

The control device 120 detects, by using the fifth interface 120e, a voltage value provided by the external power supply 150 for the electrical device. When the voltage value is less than a preset power supply voltage, the control chip 120 considers that the external power supply 150 is in a power-off state. The fifth interface 120e may be an INT interface in the control chip 120.

The functional chips 140 include at least a clock (clock) chip, a flash memory (Flash EEPROM Memory or Flash) chip, a main memory (Double Data Rate, DDR) chip, and the like. The functional chips are merely used as an example for describing some of chips that need to obtain electric energy for working. Other functional chips in the electrical device that require electric energy for working also fall within the protection scope of the functional chips 140. All functional chips 140 are disposed, according to different rated voltages for working of the functional chips 140, to be connected to output ends of corresponding voltage step-down modules 132.

Referring to FIG. 1, FIG. 1 is a schematic diagram of a flow direction of a current when a backup power circuit is being charged according to an embodiment of the present invention. As shown in FIG. 1, for example, the electrical device is a storage device, and when the storage device works normally, first the storage device accesses a host device. The host device may be an electronic device, such as a personal computer, a workstation, a server, or a server cluster, that can perform a read/write operation on the storage device. After the storage device accesses the host device, the storage device obtains electric energy from an external power supply 150 provided by the host device. After the storage device obtains the electric energy, a current provided by the external power supply 150 flows into a fifth diode 117c, and the current flows out in two branches: One branch flows into and stops at a negative electrode of a fourth diode 117b. The other branch is divided into branches whose quantity corresponds to a quantity of voltage step-down modules 132 in a power supply module 130, and the branches respectively flow into the corresponding voltage step-down modules 132. The branches of currents flowing into the corresponding voltage step-down modules 132 are respectively converted into output currents of different voltages after the branches of currents are stepped down, and the output currents flow into functional chips 140 (and a control chip 120) electrically connected to the corresponding voltage step-down modules 132. After obtaining electric energy, the control chip 120 is reset, and loads firmware (Firmware, FW). In addition, the functional chips 140 also start working normally after obtaining electric energy and completing resetting. The entire storage device starts normal data reading/writing and exchanges data with the host device.

In addition, a current output by an output end 132a that is of the voltage step-down module 132 in the power supply module 130 and that is electrically connected to an input end 119a of a current-limiting module 119 enters the current-limiting module 119, and then flows into a voltage step-up module 113 by using an input end 113a of the voltage step-up module 113. The voltage step-up module 113 is in an enabled state by default, or the voltage step-up module 130 may be enabled by means of controlling by the control chip 120 by using a control end 113c. When the voltage step-up module 113 is in the enabled state, the voltage step-up module 113 steps up a voltagea current flowing into the input end 113a of the voltage step-up module 113, so that the voltage rises to a predefined value required for design. The predefined value is related to a rated voltage of a capacitor in each backup power branch 112. Optionally, 70% to 80% of the rated voltage is a predefined value Vcap required for design, and the value may be 17.8 V. In this embodiment of the present invention, the value of the 17.8 V voltage is merely used as an example for description, and imposes no limitation on Vcap. Vcap is a charge voltage when each backup power branch 112 is being charged.

After the voltage step-up module 113 is enabled, the current flowing into the voltage step-up module 113 flows out from an output end 113b of the voltage step-up module 113 and then is divided into two branches: One branch flows into an input end 114 of a backup power branch array 111, and the other branch flows into a positive electrode of a third diode 117a. A current flowing into the input end 114 of the backup power branch array 111 is used to charge capacitors in N backup power branches 112.

It should be specially noted that a constant current source 118 is in a non-working state when an enabling command that is sent by the control chip 120 by using a fourth interface 120d is not obtained. That is, the constant current source 118 is in an open-circuited state.

As a voltage at an input end 115a of a voltage step-down module 115 gradually rises to a minimum working voltage of the voltage step-down module 115, the voltage step-down module 115 enters a normal working state and is automatically enabled. It should be specially noted that a voltage output by the voltage step-down module 115 needs to be less than a power supply voltage provided by the external power supply 150, and greater than a minimum working voltage of the voltage step-down modules 132 in the power supply module 130. Optionally, the minimum working voltage may be 1 V. A value of the voltage Vstangby that needs to be output by the voltage step-down module 115 may be 6.8 V, and the value imposes no limitation on the voltage that needs to be output by the voltage step-down module 115. In this case, because the external power supply 150 supplies power normally, the voltage output by the voltage step-down module 115 is less than the power supply voltage provided by the external power supply 150. Therefore, the voltage step-down module 115 does not output a current to the voltage step-down modules 132 in the power supply module 130 by using the fourth diode 117b.

Referring to FIG. 1, FIG. 1 is a schematic diagram of a flow direction of a current when a backup power circuit is being discharged according to an embodiment of the present invention. As shown in FIG. 1, a voltage step-down module 115 electrically connected to a positive electrode of a fourth diode 117b is always in a working state. When a voltage at a positive electrode of a fifth diode 117c is less than a voltage at the positive electrode of the fourth diode 117b (when an external power supply 150 is powered off), electric energy stored in the backup power circuit 110 instantly passes through a negative electrode of the fourth diode 117b, and flows, in a form of a current, into voltage step-down modules 132 in a power supply module 130, until a voltage of a capacitor in a backup power branch array 111 is less than a minimum working voltage of the voltage step-down module 115, so as to ensure that an electrical device (such as a storage device) can further work normally for a period of time by using the electric energy stored in the backup power circuit.

In FIG. 1, the backup power circuit 110 is divided into N backup power branches 112 (which are denoted as "first group", "second group", ..., and "N^{th} group" in FIG. 1), and each backup power branch 112 includes M capacitors. It is assumed that a capacitor in a backup power branch 112 is short-circuited. For example, in FIG. 1, a short-circuited capacitor is located in the N^{th} backup power branch. Because M capacitors in one branch are connected in parallel, capacitors in the backup power branch are all short-circuited, and electric energy stored by the N^{th} backup power branch 112 is lost. However, due to existence of a first diode 112b and a second diode 112c, electric energy in other backup power branches 112 cannot enter the N^{th} backup power branch 112. Therefore, the other backup power branches 112 can have a backup power effect. In addition, the first diode 112b can further prevent a current from flowing back into a voltage step-up module 113 from the backup power branch 112 when the external power supply 150 is powered off. In addition, in order to avoid leakage of a large quantity of currents from a short-circuited capacitor when the capacitor is short-circuited, a resistance of a resistor 112d needs to be set to be large enough, so that when a capacitor in the N^{th} backup power branch 112 is short-circuited, a current passing through the resistor 112d in the N^{th} backup power branch 112 is small enough, so as to minimize impact of electric leakage caused by the short-circuited capacitor. The resistance of the resistor 112d needs to satisfy (Vcap/R)^{∗}N<A0-A1. A0 is a maximum charge current of the backup power circuit, the maximum charge current may be a preset maximum current determined by a current-limiting module 119, and A1 is a preset current value. Optionally, A1 may be a value greater than 10 mA.

It should be specially noted that there are N backup power branches as designed in the present invention, and the N backup power branches include some redundant backup power branches. That is, when the external power supply 150 is powered off, to meet a maximum backup power requirement of the electrical device, only less than N backup power branches need to work normally. That is, (N-x) backup power branches may be disposed for normal working, and in this case, the maximum backup power requirement of the electrical device can be met, where x is an integer greater than or equal to 1, x is a quantity of redundant backup power branches, and a value of N should not be excessively large. Usually, a maximum value of N is 10. The preferred value solution imposes no limitation on the value of N in the present invention. Specifically, in order that if the (N-x) backup power branches work normally, the maximum backup power requirement of the electrical device can be met, when capacitances of the capacitors in the backup power circuit are equal, a capacitance of each capacitor is Cmin, and Cmin satisfies Cmin^{∗}M^{∗}(N-x)^{∗}(Vmax-Vmin)≥Q, where x is an integer greater than or equal to 1, Vmax is a maximum discharge voltage of the backup power branch array, Vmin is a minimum discharge voltage of the backup power branch array, and Q is a quantity of electric charges required for effectively supplying power to the electrical device for preset duration. Vmax may be the foregoing Vcap, and Vmin may be the foregoing V_{standby}.

In this embodiment of the present invention, control device may detect a capacitance of the backup power branch array 111 by controlling discharge of a constant current source 118, so as to implement a self-test of the backup power circuit. Referring to FIG. 1, FIG. 1 is a schematic diagram of a flow direction of a current when a backup power circuit performs a self-test according to an embodiment of the present invention. Specifically, when detecting a capacitance of a backup power branch array 111, a control chip 120 controls the backup power circuit 110 to stop charging, and controls a constant current source 118 to discharge at a constant current 10. For example, the control chip 120 may control, by using a third interface 120c, a voltage step-up module 113 to stop outputting a current, so as to stop charging the backup power circuit 110. Then, the control chip 120 controls, by using a fourth interface 120d, the constant current source 118 to be enabled, so that the backup power circuit 110 discharges at the constant current 10 by using a branch in which the constant current source 118 is located.

In a process in which the backup power circuit 110 discharges at the constant current 10 by using the branch in which the constant current source 118 is located, the control chip 120 detects a voltage at a current input end 118a of the constant current source 118 by using a second interface 120b. Because the current input end 118a of the constant current source 118 is electrically connected to an output end 116 of the backup power branch array 111, equivalently, the control chip 120 detects a voltage at the output end 116 of the backup power branch array 111 by using the second interface 120b. In this embodiment of the present invention, two voltage values, that is, a first preset voltage value V1 and a second preset voltage value V2 may be preset. The control chip 120 measures a time TO taken for the voltage at the current input end 118a of the constant current source 118 to decrease from the first preset voltage value V1 to the second preset voltage value V2, and V1 is greater than V2. In this case, in the backup power circuit 110, the capacitance of the backup power branch array 111 satisfies C=I0T0/(V1-V2). In an actual operation, values of V1 and V2 may be selected according to an easy-to-obtain and error reduction rule.

Optionally, a value of V1 may be (Vcap-500 mV), and a value of V2 may be (Vcap-1000 mV). A value of Vcap is a voltage at the output end 116 of the backup power branch array 111 after charging of the backup power circuit 110 is complete, that is, a voltage value at an output end 113b of the voltage step-up module 113 when the voltage step-up module 113 is enabled. After the measurement is complete, the control chip 120 disables the constant current source 118 by using the fourth interface 120d, so that the constant current source 118 is open-circuited. In addition, the control chip 120 enables the voltage step-up module 113 by using the third interface 120c, to control the voltage step-up module 113 to continue to charge the backup power branch array 111. In this case, the electrical device completes measurement of the capacitance of the backup power branch array 111, and the backup power circuit 110 returns to a normal backup power state.

That a backup power branch 112 is in an effective working state means that none of M capacitors in the backup power branch 112 is short circuited.

In conclusion, according to the electrical device provided in the foregoing embodiments, the backup power branch array including the N backup power branches that are mutually connected in parallel is disposed in the backup power circuit. The control chip of the electrical device measures the capacitance of the backup power branch array; determines whether the capacitance is less than the first preset threshold; and if the capacitance is less than the first preset threshold, notifies that the duration for which the backup power circuit can effectively supply power to the electrical device is less than the preset duration. A plurality of backup power branches are disposed in the backup power circuit, and the capacitance of the backup power branch array in the backup power circuit is detected regularly. When some backup power branches are short-circuited, a user can be reminded in a timely manner, so that the user takes a necessary remedial measure before the backup power circuit totally fails, thereby improving a backup power effect of the backup power circuit.

It should be understood that, unless an exception is specified clearly in the context, a singular form "one" ("a", "an" or "the") used in this specification is intended to also include a plural form. It should be further understood that "and/or" used in this specification is any or all possible combinations including one or more listed related items.

The sequence numbers of the foregoing embodiments of the present invention are merely for illustration purposes, and are not intended to indicate priorities of the embodiments.

A person of ordinary skill in the art may understand that all or some of the steps of the embodiments may be implemented by hardware or a program instructing relevant hardware. The program may be stored in a computer-readable storage medium. The foregoing mentioned storage medium may include a read-only memory, a disk, an optical disc, or the like.

The foregoing descriptions are merely example embodiments of the present invention, but are not intended to limit the present invention. Any modification, equivalent replacement, and improvement to the embodiments in the description is possible when falling under the scope of the invention as defined in the appended claims.

## Claims

1. A backup power circuit (110), wherein an output end of the backup power circuit (110) is electrically connectable to an input end of a power supply circuit (130) of an electrical device, an input end of the backup power circuit (110) is connectable to an output end of the power supply circuit (130), the backup power circuit (110) comprises a backup power branch array (111) comprising N backup power branches (112) that are mutually connected in parallel, N is an integer greater than or equal to 2, and each backup power branch (112) comprise a capacitor component (112a) and a unilateral conductive element (112k);
the unilateral conductive element (112k) is electrically connected to an input end (114) of the backup power branch array (111), an output end (116) of the backup power branch array (111), and the capacitor component (112a) separately; and
the unilateral conductive element (112k) is configured to: cut off a current path between the N backup power branches (112) that are mutually connected in parallel, and allow a current to flow into the input end (114) of the backup power branch array (111) and flow out from the output end (116) of the backup power branch array (111), wherein the unilateral conductive element (112k) comprises a first diode (112b) and a second diode (112c); and
a negative electrode of the first diode (112b) is electrically connected via a resistor (112d) to a positive electrode of the second diode (112c), a positive electrode of the first diode (112b) is electrically connected to the input end (114) of the backup power branch array (111), and a negative electrode of the second diode (112c) is electrically connected to the output end (116) of the backup power branch array (111); and the capacitor component (112a) comprises M capacitors that are mutually connected in parallel, one end of each capacitor is connected between the negative electrode of the first diode (112b) and the positive electrode of the second diode (112c), the other end of each capacitor is grounded, and M is an integer greater than or equal to 1, wherein a capacitance of each capacitor is Cmin, and Cmin satisfies Cmin^{∗}M^{∗}(N-x)^{∗}(Vmax-Vmin)≥Q, wherein
x is an integer greater than or equal to 1, Vmax is a maximum discharge voltage of the backup power branch array (111), Vmin is a minimum discharge voltage of the backup power branch array (111), and Q is a quantity of electric charges required for effectively supplying power to the storage device for a preset duration, wherein each backup power branch (112) further comprise a resistor (112d), one end of the resistor (112d) is electrically connected to the negative electrode of the first diode (112b), and the other end of the resistor (112d) is electrically connected to the positive electrode of the second diode (112c); and one end of each capacitor is connected between the resistor (112d) and the positive electrode of the second diode (112c);
wherein the resistor is disposed in the backup power branch to limit a value of a current of the backup power branch when the capacitor in the backup power branch is short-circuited, so that another backup power branch can obtain a sufficient current for charging.

2. The backup power circuit (110) according to claim 1, wherein a resistance R of the resistor (112d) satisfies: $\left(Vcap/R\right) ∗ N < A 0 - A 1 ,$ wherein
Vcap is a charge voltage of the N backup power branch (112) that are mutually connected in parallel, A0 is a maximum charge current of the backup power circuit (110), and A1 is a preset current value.

3. The backup power circuit (110) according to claim 1, wherein the backup power circuit (110) further comprises a third diode (117a); and
the third diode (117a) is connected to the backup power branch array in parallel, wherein a positive electrode of the third diode (117a) is electrically connected to the input end (114) of the backup power branch array (111), and a negative electrode of the third diode (117a) is electrically connected to the output end (116) of the backup power branch array (111).

4. The backup power circuit (110) according to claim 1, wherein the backup power circuit (110) further comprises a constant current source (118);
the constant current source (118) comprises an input end (118a), an output end (118b), and a control end (118c);
the input end (118a) of the constant current source (118) is electrically connected to the output end (116) of the backup power branch array (111);
the output end (118b) of the constant current source (118) is grounded; and
the control end (118c) of the constant current source (118) is electrically connected to a control chip (120).

5. The backup power circuit (110) according to any one of claims 1 to 4, wherein each of the M capacitors that are mutually connected in parallel is at least one of an electrolytic aluminum capacitor, a polymer solid tantalum capacitor, a polymer solid aluminum capacitor, or a ceramic capacitor.

6. An electrical device, wherein the electrical device comprises the backup power circuit (110) according to any one of claims 1 to 5.

7. The electrical device according to claim 6, wherein the electrical device is a storage device.

## Patentansprüche

1. Notstromschaltung (110), wobei ein Ausgangsende der Notstromschaltung (110) elektrisch mit einem Eingangsende einer Stromversorgungsschaltung (130) einer elektrischen Vorrichtung verbindbar ist, wobei ein Eingangsende der Notstromschaltung (110) mit einem Ausgangsende der Stromversorgungsschaltung (130) verbindbar ist, wobei die Notstromschaltung (110) eine Notstrom-Zweiganordnung (111) umfasst, die N Notstrom-Zweige (112) umfasst, die miteinander parallel geschaltet sind, wobei N eine ganze Zahl von wenigstens 2 ist, und wobei jeder Notstrom-Zweig (112) eine Kondensatorkomponente (112a) und ein einseitig leitendes Element (112k) umfasst;
das einseitig leitende Element (112k) elektrisch mit einem Eingangsende (114) der Notstrom-Zweiganordnung (111), einem Ausgangsende (116) der Notstrom-Zweiganordnung (111) und der Kondensatorkomponente (112a) separat verbunden ist; und
das einseitig leitende Element (112k) für Folgendes konfiguriert ist:
Unterbrechen eines Strompfades zwischen den N Notstrom-Zweigen (112), die miteinander parallel geschaltet sind, und Ermöglichen, dass ein Strom in das Eingangsende (114) der Notstrom-Zweiganordnung (111) fließt und aus dem Ausgangsende (116) der Notstrom-Zweiganordnung (111) herausfließt, wobei das einseitig leitende Element (112k) eine erste Diode (112b) und eine zweite Diode (112c) umfasst; und
eine negative Elektrode der ersten Diode (112b) elektrisch über einen Widerstand (112d) mit einer positiven Elektrode der zweiten Diode (112c) verbunden ist, eine positive Elektrode der ersten Diode (112b) elektrisch mit dem Eingangsende (114) der Notstrom-Zweiganordnung (111) verbunden ist, und eine negative Elektrode der zweiten Diode (112c) elektrisch mit dem Ausgangsende (116) der Notstrom-Zweiganordnung (111) verbunden ist; und die Kondensatorkomponente (112a) M Kondensatoren umfasst, die miteinander parallel geschaltet sind, wobei ein Ende jedes Kondensators zwischen die negative Elektrode der ersten Diode (112b) und die positive Elektrode der zweiten Diode (112c) geschaltet ist, und das andere Ende jedes Kondensators geerdet ist, und M eine ganze Zahl von wenigstens 1 ist, wobei eine Kapazität jedes Kondensators Cmin ist und Cmin Cmin^{∗}M^{∗}(N-x)^{∗}(Vmax-Vmin)≥Q erfüllt, wobei
x eine ganze Zahl von wenigstens 1 ist, Vmax eine maximale Entladungsspannung der Notstrom-Zweiganordnung (111) ist, Vmin eine minimale Entladungsspannung der Notstrom-Zweiganordnung (111) ist, und Q eine Menge elektrischer Ladungen ist, die erforderlich ist, um der Speichervorrichtung für eine voreingestellte Dauer effektiv Strom zuzuführen, wobei jeder Notstrom-Zweig (112) ferner einen Widerstand (112d) umfasst, ein Ende des Widerstandes (112d) elektrisch mit der negativen Elektrode der ersten Diode (112b) verbunden ist und das andere Ende des Widerstandes (112d) elektrisch mit der positiven Elektrode der zweiten Diode (112c) verbunden ist; und ein Ende jedes Kondensators zwischen dem Widerstand (112d) und der positiven Elektrode der zweiten Diode (112c) verbunden ist;
wobei der Widerstand in dem Notstrom-Zweig arrangiert ist, um einen Wert eines Stroms des Notstrom-Zweiges zu begrenzen, wenn der Kondensator in dem Notstrom-Zweig kurzgeschlossen wird, so dass ein anderer Notstrom-Zweig einen ausreichenden Strom zum Laden erhalten kann.

2. Notstromschaltung (110) nach Anspruch 1, wobei eine Resistenz R des Widerstandes (112d) Folgendes erfüllt: $\left(Vcap/R\right) * N < A 0 - A 1 ,$ wobei
Vcap eine Ladungsspannung der N Notstrom-Zweige (112) ist, die miteinander parallel geschaltet sind, A0 ein maximaler Ladungsstrom der Notstromschaltung (110) ist und A1 ein voreingestellter Stromwert ist.

3. Notstromschaltung (110) nach Anspruch 1, wobei die Notstromschaltung (110) ferner eine dritte Diode (117a) umfasst; und
die dritte Diode (117a) mit der Notstrom-Zweiganordnung parallel geschaltet ist, wobei eine positive Elektrode der dritten Diode (117a) elektrisch mit dem Eingangsende (114) der Notstrom-Zweiganordnung (111) verbunden ist, und eine negative Elektrode der dritten Diode (117a) elektrisch mit dem Ausgangsende (116) der Notstrom-Zweiganordnung (111) verbunden ist.

4. Notstromschaltung (110) nach Anspruch 1, wobei die Notstromschaltung (110) ferner eine Konstantstromquelle (118) umfasst;
die Konstantstromquelle (118) ein Eingangsende (118a), ein Ausgangsende (118b) und ein Steuerende (118c) umfasst;
das Eingangsende (118a) der Konstantstromquelle (118) elektrisch mit dem Ausgangsende (116) der Notstrom-Zweiganordnung (111) verbunden ist;
das Ausgangsende (118b) der Konstantstromquelle (118) geerdet ist; und
das Steuerende (118c) der Konstantstromquelle (118) elektrisch mit einem Steuerchip (120) verbunden ist.

5. Notstromschaltung (110) nach einem der Ansprüche 1 bis 4, wobei jeder der M Kondensatoren, die miteinander parallel geschaltet sind, ein elektrolytischer Aluminiumkondensator, ein Polymer-Feststoff-Tantal-Kondensator, ein Polymer-Feststoff-Aluminium-Kondensator und/oder ein Keramikkondensator ist.

6. Elektrische Vorrichtung, wobei die elektrische Vorrichtung die Notstromschaltung (110) nach einem der Ansprüche 1 bis 5 umfasst.

7. Elektrische Vorrichtung nach Anspruch 6, wobei die elektrische Vorrichtung eine Speichervorrichtung ist.

## Revendications

1. Circuit d'alimentation de secours (110), une extrémité de sortie du circuit d'alimentation de secours (110) pouvant être connectée électriquement à une extrémité d'entrée d'un circuit de fourniture d'alimentation (130) d'un dispositif électrique, une extrémité d'entrée du circuit d'alimentation de secours (110) pouvant être connectée à une extrémité de sortie du circuit de fourniture d'alimentation (130), le circuit d'alimentation de secours (110) comprenant un réseau de branches d'alimentation de secours (111) comprenant N branches d'alimentation de secours (112) qui sont mutuellement connectées en parallèle, N étant un nombre entier supérieur ou égal à 2, et chaque branche d'alimentation de secours (112) comprenant un composant à condensateurs (112a) et un élément conducteur unilatéral (112k) ;
l'élément conducteur unilatéral (112k) étant connecté électriquement à une extrémité d'entrée (114) du réseau de branches d'alimentation de secours (111), à une extrémité de sortie (116) du réseau de branches d'alimentation de secours (111) et au composant à condensateurs (112a) séparément ; et
l'élément conducteur unilatéral (112k) étant configuré pour : couper un chemin de courant entre les N branches d'alimentation de secours (112) qui sont mutuellement connectées en parallèle, et permettre à un courant de circuler de manière à entrer dans l'extrémité d'entrée (114) du réseau de branches d'alimentation de secours (111) et de circuler de manière à sortir à partir de l'extrémité de sortie (116) du réseau de branches d'alimentation de secours (111), l'élément conducteur unilatéral (112k) comprenant une première diode (112b) et une deuxième diode (112c) ; et
une électrode négative de la première diode (112b) étant connectée électriquement par l'intermédiaire d'une résistance (112d) à une électrode positive de la deuxième diode (112c), une électrode positive de la première diode (112b) étant connectée électriquement à l'extrémité d'entrée (114) du réseau de branches d'alimentation de secours (111), et une électrode négative de la deuxième diode (112c) étant connectée électriquement à l'extrémité de sortie (116) du réseau de branches d'alimentation de secours (111) ; et le composant à condensateurs (112a) comprenant M condensateurs qui sont mutuellement connectés en parallèle, une extrémité de chaque condensateur étant connectée entre l'électrode négative de la première diode (112b) et l'électrode positive de la deuxième diode (112c), l'autre extrémité de chaque condensateur étant mis à la terre, et M étant un nombre entier supérieur ou égal à 1, une capacité de chaque condensateur étant Cmin, et Cmin satisfaisant Cmin ^{∗} M ^{∗} (N - x) ^{∗} (Vmax - Vmin) ≥ Q,
x étant un nombre entier supérieur ou égal à 1, Vmax étant une tension de décharge maximale du réseau de branches d'alimentation de secours (111), Vmin étant une tension de décharge minimale du réseau de branches d'alimentation de secours (111), et Q étant une quantité de charges électriques nécessaire pour fournir efficacement de l'alimentation au dispositif de stockage pendant une durée prédéfinie, chaque branche d'alimentation de secours (112) comprenant en outre une résistance (112d), une extrémité de la résistance (112d) étant connectée électriquement à l'électrode négative de la première diode (112b), et l'autre extrémité de la résistance (112d) étant connectée électriquement à l'électrode positive de la deuxième diode (112c) ; et une extrémité de chaque condensateur étant connectée entre la résistance (112d) et l'électrode positive de la deuxième diode (112c) ;
la résistance étant disposée dans la branche d'alimentation de secours pour limiter une valeur d'un courant de la branche d'alimentation de secours lorsque le condensateur dans la branche d'alimentation de secours est court-circuité, de telle sorte qu'une autre branche d'alimentation de secours peut obtenir un courant suffisant pour la charge.

2. Circuit d'alimentation de secours (110) selon la revendication 1, une résistance R de la résistance (112d) satisfaisant : $\left(Vcap/R\right) * N < A 0 - A 1 ,$ Vcap étant une tension de charge de N branches d'alimentation de secours (112) qui sont mutuellement connectées en parallèle, A0 étant un courant de charge maximale du circuit d'alimentation de secours (110) et A1 étant une valeur de courant prédéfinie.

3. Circuit d'alimentation de secours (110) selon la revendication 1, le circuit d'alimentation de secours (110) comprenant en outre une troisième diode (117a) ; et
la troisième diode (117a) étant connectée au réseau de branches d'alimentation de secours en parallèle, une électrode positive de la troisième diode (117a) étant connectée électriquement à l'extrémité d'entrée (114) du réseau de branches d'alimentation de secours (111), et une électrode négative de la troisième diode (117a) étant connectée électriquement à l'extrémité de sortie (116) du réseau de branches d'alimentation de secours (111).

4. Circuit d'alimentation de secours (110) selon la revendication 1, le circuit d'alimentation de secours (110) comprenant en outre une source de courant constant (118) ;
la source de courant constant (118) comprenant une extrémité d'entrée (118a), une extrémité de sortie (118b) et une extrémité de contrôle (118c) ;
l'extrémité d'entrée (118a) de la source de courant constant (118) étant connectée électriquement à l'extrémité de sortie (116) du réseau de branches d'alimentation de secours (111) ;
l'extrémité de sortie (118b) de la source de courant constant (118) étant mise à la terre ; et
l'extrémité de contrôle (118c) de la source de courant constant (118) étant connectée électriquement à une puce de contrôle (120).

5. Circuit d'alimentation de secours (110) selon l'une quelconque des revendications 1 à 4, chacun des M condensateurs qui sont mutuellement connectés en parallèle étant un condensateur électrolytique en aluminium, et/ou un condensateur au tantale solide polymère, et/ou un condensateur polymère en aluminium solide, et/ou un condensateur céramique.

6. Dispositif électrique, le dispositif électrique comprenant le circuit d'alimentation de secours (110) selon l'une quelconque des revendications 1 à 5.

7. Dispositif électrique selon la revendication 6, le dispositif électrique étant un dispositif de stockage.
